# EUROPÄISCHE PATENTSCHRIFT

(11) **EP 3 504 733 B1**
(45) Veröffentlichungstag und Bekanntmachung des Hinweises auf die Patenterteilung: **23.09.2020**
(21) Anmeldenummer: 16774860.7
(22) Anmeldetag: 29.08.2016
(51) Int. Cl.: H01L 21/67, H01L 21/68

(54) **VERFAHREN UND VORRICHTUNG ZUM AUSRICHTEN VON SUBSTRATEN**
METHOD AND APPARATUS FOR ALIGNING SUBSTRATES
MÉTHODE ET APPAREIL POUR L'ALIGNEMENT DE SUBSTRATS

(43) Veröffentlichungstag der Anmeldung: 03.07.2019
(60) Teilanmeldung: 20182353.1
(73) Patentinhaber: EV Group E. Thallner GmbH, 4782 St. Florian am Inn (AT)
(72) Erfinder: WAGENLEITNER, Thomas, 4971 Aurolzmünster (AT); ZINNER, Dominik, 4755 Zell an der Pram (AT); SÜSS, Jürgen Markus, 4791 Rainbach (AT); SINN, Christian, 4770 Andorf (AT); MALLINGER, Jürgen, 4971 Senftenbach (AT)
(74) Vertreter: Schneider, Sascha
(86) Internationale Anmeldenummer: PCT/EP2016/070289
(87) Internationale Veröffentlichungsnummer: WO 2018/041326

(56) Entgegenhaltungen:
- WO-A1-2010/023935
- WO-A1-2016/114329
- JP-A- 2005 251 972
- JP-A- 2007 208 031
- US-A1- 2013 244 350
- US-A1- 2016 240 420

## Beschreibung

Die vorliegende Erfindung betrifft ein Verfahren zum Ausrichten und Kontaktieren eines ersten Substrats mit einem zweiten Substrat sowie eine korrespondierende Vorrichtung. Die Erfindung wird durch den angehängten Satz von Ansprüchen definiert. Ausführungsbeispiele in der Beschreibung, die nicht in den Rahmen dieser Ansprüche fallen sind als Vergleichsbeispiele zu betrachten.

In der Halbleiterindustrie werden Ausrichtungsanlagen (engl.: aligner) verwendet, um Substrate, insbesondere Wafer, zueinander auszurichten, damit sie in einem weiteren Prozessschritt miteinander verbunden werden. Der Verbindungsvorgang wird Bonden genannt.

Ausrichtungsvorgänge, bei denen sich die Ausrichtungsmarkierungen an den zu verbondenden Substratoberflächen befinden werden als face-to-face Ausrichtungen bezeichnet.

Soweit die Substrate für die elektromagnetische Strahlung, welche zur Vermessung der Substrate verwendet wird nicht transparent sind, um eine Erfassung und/oder Bestimmung der Position und Lage der Ausrichtungsmarkierungen von den zu verbondenden Substratoberflächen abgewandten, äußeren Substratoberflächen her zu ermöglichen, werden Ausrichtungsmarkierungen mit Bilderfassungsmittel zwischen den Substraten erfasst bevor die Substrate aneinander angenähert werden.

Dies hatte verschiedene Nachteile, insbesondere Partikelkontamination durch die Kamera und ein großer Abstand zwischen den Substraten, um die Kamera zur Erfassung zwischen beiden Substraten zu platzieren. Hieraus ergeben sich Ausrichtungsfehler bei der gegenseitigen Annäherung.

Eine Verbesserung der face-to-face Ausrichtung stellt die Ausrichtungsanlage der Druckschrift US6214692B1 dar, welche als nächstliegender Stand der Technik betrachtet werden kann. Bei dieser werden zwei Optikgruppen mit jeweils zwei zueinander gegenüberliegenden Optiken verwendet, um ein System mit zwei Referenzpunkten zu schaffen, in Bezug auf das die Substrate wechselseitig positioniert werden. Bei den Referenzpunkten handelt es sich um die Schnittpunkte der optischen Achsen zweier zueinander gegenüberliegender Optiken.

Das Problem mit dem Stand der Technik besteht darin, dass die steigenden Ausrichtungsgenauigkeitsanforderungen nicht mehr durch die offenbarten offenen, gesteuerten Verfahren erreichbar sind.

Die Druckschrift US6214692B1 basiert auf dem Vergleich und der Positionskorrektur zweier Bilder von Ausrichtungsmarkierungen. Die Lage von Ausrichtungsmarkierungen auf den beiden, face-to-face angeordneten Substraten wird einzeln mittels eines Kamerasystems erfasst. Aus einer berechneten Relativlage und Relativposition der Ausrichtungsmarkierungen wird ein Positioniertisch (Substrathalter und Stage) so angesteuert, dass die Fehlposition korrigiert wird. Der Positioniertisch verfügt über führungssowie antriebsnah positionierte inkrementelle Weggeber.

Die Dokumente JP2005-251972-A, WO2010/023935-A1 und US2013/0244350-A1 geben weitere Vorrichtungen und Verfahren zum. Ausrichten und Kontaktieren von Substraten an.

Aufgabe der vorliegenden Erfindung ist es daher, eine Vorrichtung und ein Verfahren zum Ausrichten und Kontaktieren von Substraten anzugeben, mit dem eine genauere und effizientere Ausrichtung und Kontaktierung von Substraten ermöglicht wird.

Diese Aufgabe wird mit den Merkmalen der Ansprüche 1 und 10 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt der Gedanke zugrunde, vor einer Ausrichtung zusätzlich eine Erfassung einer zusätzlichen (insbesondere dritten) Ausrichtungsmarkierung vorzunehmen, die entweder an einem der auszurichtenden Substrate oder am Substrathalter angebracht ist. Insbesondere ist die zusätzliche Ausrichtungsmarkierung nicht an den Kontaktflächen der Substrate angeordnet. Vorzugsweise ist die zusätzliche Ausrichtungsmarkierung an einer von der Kontaktfläche abgewandten oder zur Kontaktfläche parallel angeordneten Seite des Substrats oder des Substrathalters angeordnet.

Die Ausrichtung der Substrate zueinander erfolgt insbesondere mittelbar an Hand von Ausrichtungsmarkierungen, die an Kontaktflächen der Substrate befinden. Die Ausrichtungsmarkierungen an gegenüberliegenden Seiten der gegenüberliegenden Substrate sind insbesondere komplementär zueinander. Ausrichtungsmarkierungen können jegliche, zueinander ausrichtbare Objekte wie Kreuze, Kreise oder Quadrate oder propellerartige Gebilde oder Gitterstrukturen, insbesondere Phasengitter für den Ortsfrequenzbereich, sein.

Die Ausrichtungsmarkierungen werden mit Vorzug mittels elektromagnetischer Strahlung bestimmter Wellenlänge und/oder Wellenlängenbereiche erfasst. Diese umfassen zur Zeit Infrarotstrahlung, sichtbares Licht oder ultraviolette Strahlung. Es ist jedoch die Verwendung von Strahlung kürzerer Wellenlänge wie EUV oder Röntgenstrahlung ebenfalls möglich.

Ein - insbesondere eigenständiger - Aspekt der vorliegenden Erfindung ist es, dass die Ausrichtung, insbesondere ausschließlich, mittels der Erfassung der zusätzlichen Ausrichtungsmarkierung erfolgt. Mit ausschließlich ist gemeint, dass die anderen (insbesondere erste und zweite) Ausrichtungsmarkierungen während der Ausrichtung nicht erfasst werden oder erfassbar sind.

Gemäß einer vorteilhaften Ausführungsform der Erfindung ist das erste Substrat und das zweite Substrat zwischen dem ersten Substrathalter und dem zweiten Substrathalter mit einem Abstand A zwischen der ersten Kontaktfläche und der zweiten Kontaktfläche in einer Z-Richtung angeordnet. Der Abstand A beträgt insbesondere weniger als 500 Mikrometer, besonders bevorzugt weniger als 100 Mikrometer, im optimalen Fall weniger als 50 Mikrometer, im Idealfall weniger als 10 Mikrometer.

Das erfindungsgemäße Verfahren ist insbesondere ein Verfahren zur face-to-face Ausrichtung mindestens zweier Substrate mit einer beliebigen elektromagnetischen Strahlung, insbesondere mit UV Licht, noch bevorzugter mit Infrarotlicht, am bevorzugtesten mit sichtbarem Licht und/oder sequentieller Freigabe optischer Pfades für die Betrachtung der ersten und zweiten Ausrichtungsmarkierungen, wobei eine Ergänzung mit mindestens einem zusätzlichen optischen Pfad für die genaue Wiederherstellung der Substrat- und Substrathalterposition vorgesehen ist, der bei der Ausrichtung der Substrate nicht zwischen den Substraten angeordnet ist oder verläuft, sondern eine Erfassung von außerhalb ermöglicht.

Das erfindungsgemäße Verfahren erhöht die Ausrichtungsgenauigkeit insbesondere mittels zusätzlichen X-Y-Positions- und/oder Lageinformationen, welche mit zusätzlich angebrachten Erfassungseinheiten und/oder Mess- und Regelsystemen erfasst und zur Steuerung der Ausrichtung werden.

Hierfür weist die erfindungsgemäße Vorrichtung eine, insbesondere softwaregestützte, Steuerungseinheit auf, mittels der die hier beschriebenen Schritte und Bauteile gesteuert werden. Erfindungsgemäß sollen geschlossene Regelkreise sowie Regelungen unter der Steuerungseinheit subsummiert verstanden werden.

Mit X- und Y-Richtung oder X- und Y-Position werden in einem X-Y-Koordinatensystem beziehungsweise in einer beliebigen Z-Ebene des X-Y-Koordinatensystems verlaufende Richtungen oder angeordnete Positionen verstanden. Die Z-Richtung ist zur X-Y-Richtung orthogonal angeordnet.

Die X- und Y-Richtung entspricht insbesondere einer lateralen Richtung.

Positionsmerkmale werden aus den Positions- und/oder Lagewerten der Ausrichtungsmarkierungen der Substrate sowie von Ausrichtungsmarkierungen auf dem Substrathalter abgeleitet/berechnet.

Erfindungsgemäß wird insbesondere mindestens ein zusätzliches Positionsmerkmal mit mindestens einem zusätzlichen Messsystem mit einem neuen, zusätzlichen optischen Pfad erfasst. Die mindestens eine zusätzliche Ausrichtungsmarkierung befindet sich vorzugsweise in örtlicher Nähe zu den Ausrichtungsmarkierungen der Substrate.

Das erfindungsgemäße Verfahren und die erfindungsgemäße Vorrichtung weisen somit insbesondere mindestens ein zusätzliches Mess- und/oder Regelsystem auf, wobei durch zusätzliche Messwerte und Korrelationen mit mindestens einem der Messwerte der anderen Erfassungseinheiten die Ausrichtungsgenauigkeit erhöht wird. Durch Korrelation mindestens einer der vermessenen Ausrichtungsmarkierungen im Bondinterface zwischen den Kontaktflächen mit einer auch bei der Ausrichtung der Substrate sichtbaren Ausrichtungsmarkierung wird die direkte Beobachtbarkeit einer Ausrichtungsmarke und somit eine Echtzeitmessung und Regelung während der Ausrichtung ermöglicht. Somit steigt die Ausrichtungsgenauigkeit der Substrate.

Die zusätzliche Ausrichtungsmarkierung ist insbesondere auf der Rückseite des Substrathalters angeordnet.

Zwischen dem zusätzlich hinzugefügten Positionsmerkmal auf dem Substrathalter und den Positionsmerkmalen auf den Substraten wird insbesondere eine eindeutige Korrelation hergestellt, die vorzugsweise bis zur und während der Ausrichtung nicht verändert wird.

Durch die zusätzlich hinzugefügten Positionsmerkmale am Substrathalter, die eindeutig mit den Positionsmerkmalen auf dem Substrat korreliert sind, kann eine direkte Beobachtung der Positionsmerkmale auf dem Substrat durch eine direkte Beobachtung der Positionsmerkmale am Substrathalter ersetzt werden. Dies hat den Vorteil, dass der beobachtbare Teil des Substrathalters praktisch immer im Sichtfeld bzw. Messbereich des zusätzlichen Messsystems angeordnet werden kann.

Eine aktive Rückführung der Daten für die Positionierung und Positionskorrektur erhöht die Genauigkeit im Vergleich zu einer gesteuerten Positionierung im Stand der Technik, da in geschlossenen Regelkreisen eine Kontrollmöglichkeit des Ist-Standes der Position gegeben ist. Dadurch wird insbesondere nicht eine vorgegebene Strecke mit einer gegebenen Anzahl an Inkrementen gefahren, sondern die bereits gefahrene Strecke gemessen, sodass ein Vergleich zwischen Soll und Ist, insbesondere bezüglich Geschwindigkeiten und/oder Beschleunigungen, durchgeführt werden kann. Das Ziel der Erfindung ist die Erhöhung der Genauigkeit der Ausrichtung zweier Substrate mit einem Verfahren, mit welchem die Ausrichtung, insbesondere von außerhalb des Bondinterface in Echtzeit beobachtet werden kann. Hierbei sind die Substrate insbesondere mit minimalem Abstand zueinander angeordnet und zwischen den Substraten befindet vorzugsweise sich kein Vorrichtungsgegenstand.

Ein Kerngedanke der Erfindung ist insbesondere die Einführung mindestens eines zusätzlichen Mess- und Regelsystems und die Verknüpfung der bestehenden Messwerte mit den zusätzlichen, neu erfassten Positions- und/oder Lagewerten. Durch die Korrelation der vermessenen Ausrichtungsmarkierungen im Bondinterface mit einer während der Ausrichtung, insbesondere direkt, erfassbaren Ausrichtungsmarkierung auf dem Substrathalter, insbesondere an dessen Rückseite, und/oder dem Substrat, insbesondere an dessen Rückseite, wird die direkte Beobachtbarkeit der zusätzlichen Ausrichtungsmarkierung und eine Echtzeitmessung und -regelung ermöglicht. Durch diese Maßnahme wird die Ausrichtungsgenauigkeit verbessert.

Während der Erfassung der ersten Ausrichtungsmarkierung werden das zweite Substrat und der zweite Substrathalter in einer X-Y-Richtung aus der optischen Achse der ersten Erfassungseinheit herausgefahren, damit eine Erfassung ermöglicht wird.

Während der Erfassung der zweiten Ausrichtungsmarkierung werden das erste Substrat und der erste Substrathalter in einer X-Y-Richtung aus der optischen Achse der zweiten Erfassungseinheit herausgefahren, damit eine Erfassung ermöglicht wird.

### Vorrichtung

Die erfindungsgemäße Vorrichtung zur Ausrichtung mindestens zweier Substrate weist mindestens ein optisches System auf, bestehend aus zwei, insbesondere gegeneinander ausgerichteten Optiken oder Erfassungseinheiten, deren optischen Pfade sich vorzugsweise in einem gemeinsamen Fokuspunkt treffen.

Das optische System beinhaltet gemäß einer vorteilhaften Ausführungsform Strahlformungs- und/oder Umlenkungselemente wie Spiegel, Linsen, Prismen, Strahlungsquellen insbesondere zur Köhler'sehen Beleuchtung sowie Bilderfassungsmittel wie Kameras (CMOS-Sensoren, oder CCD, oder Flächen- oder Zeilen- oder Punkterfassungsmittel wie ein Fototransistor) und Bewegungsmittel zur Fokussierung sowie Auswertemittel zur Regelung des optischen Systems.

In einer erfindungsgemäßen Ausführungsform der Vorrichtung werden ein optisches System und ein Rotationssystem für die Substratpositionierung nach dem Prinzip der Umschlagsjustierung verwendet, s. dazu Hansen, Friedrich: Justierung, VEB Verlag Technik, 1964, Abs. 6.2.4, Umschlagmethode, bei welchem mindestens eine Messung in einer definierten Position und mindestens eine Messung in 180 Grad gedrehter, entgegengesetzt orientierter, umgeschlagener Position durchgeführt wird. Das so erhaltene Messergebnis ist insbesondere von Exzentrizitätsfehlern bereinigt.

Eine Weiterbildung der erfindungsgemäßen Vorrichtung beinhaltet zwei, insbesondere identische, baugleiche optische Systeme mit zueinander ausgerichteten und relativ zueinander fixierbaren Optiken.

Eine erfindungsgemäße Weiterbildung der Vorrichtung beinhaltet mehr als zwei identische optische Systeme mit ausgerichteten Optiken.

Weiterhin beinhaltet eine erfindungsgemäße Vorrichtung Substrathalter für die Aufnahme der auszurichtenden Substrate.

In einer weiteren Ausführungsform der erfindungsgemäßen Vorrichtung wird mindestens ein Substrathalter verwendet, welcher an definierten Stellen für die insbesondere gleichzeitige Beobachtung beider Substratseiten mindestens teilweise, bevorzugt über 95%, transparent ist.

In einer weiteren Ausführungsform der erfindungsgemäßen Vorrichtung wird mindestens ein Substrathalter verwendet, welcher an definierten Stellen für die insbesondere gleichzeitige Beobachtung beider Substratseiten Öffnungen und/oder Durchbrüche und/oder Sichtfenster aufweist.

Weiterhin kann eine erfindungsgemäße Vorrichtung ein System zur Herstellung von Pre-bonds beinhalten.

Weiterhin beinhaltet eine erfindungsgemäße Vorrichtung vorzugsweise Bewegungseinrichtungen mit Antriebssystemen, Führungssystemen, Festhaltungen sowie Messsystemen, um die optischen Systeme sowie die Substrathalter und/oder Substrate zu bewegen, zu positionieren und zueinander auszurichten.

Die Bewegungseinrichtungen können jede Bewegung als Resultat von Einzelbewegungen erzeugen, sodass die Bewegungseinrichtungen bevorzugt schnelle, den Genauigkeitsanforderungen nicht entsprechende Grobpositioniervorrichtungen sowie präzise arbeitende Feinpositioniervorrichtungen enthalten können.

Ein Sollwert der anzufahrenden Position ist ein Idealwert. Die Bewegungseinrichtung nähert sich dem Idealwert an. Ein Erreichen einer definierten Umgebung um den Idealwert kann als Erreichen des Sollwertes verstanden werden.

Als Grobpositioniervorrichtung wird eine Positioniervorrichtung verstanden, wenn die Anfahr- und/oder Wiederholgenauigkeit vom Sollwert mehr als 0,1%, bevorzugt mehr als 0,05%, besonders bevorzugt mehr als 0,01%, bezogen auf den gesamten Verfahrweg oder Rotationsbereich, bei umlauffähigen Rotationsantrieben eine volle Umdrehung von 360 Grad, abweicht.
Beispielsweise resultiert somit bei einer Grobpositioniervorrichtung mit einem Verfahrweg von über 600 mm eine Anfahrgenauigkeit von 600 mm * 0,01%, also mehr als 60 Mikrometer als Restunsicherheit.
In anderen Ausführungsformen der Grobpositionierung ist die Restunsicherheit der Anfahr- oder Wiederholgenauigkeit weniger als 100 Mikrometer, bevorzugt weniger als 50 Mikrometer, besonders bevorzugt weniger als 10 Mikrometer. Dabei sollen thermische Störgrößen vorzugsweise mitberücksichtigt werden.

Eine Grobpositioniervorrichtung erfüllt die Positionieraufgabe nur dann mit hinreichender Genauigkeit, falls zwischen der tatsächlich erreichten Ist-Position und dem Sollwert der Position die Abweichung im Verfahrbereich einer zugeordneten Feinpositioniervorrichtung liegt.

Eine alternative Grobpositioniervorrichtung erfüllt die Positionieraufgabe insbesondere nur dann mit hinreichender Genauigkeit, falls zwischen der tatsächlich erreichten Ist-Position und dem Sollwert der Position die Abweichung im halben Verfahrbereich einer zugeordneten Feinpositioniervorrichtung liegt.

Als Feinpositioniervorrichtung wird eine Positioniervorrichtung verstanden, wenn die Restunsicherheit der Anfahr- und/oder Wiederholgenauigkeit vom Sollwert weniger als 500 ppb, bevorzugt weniger als 100 ppb, im Idealfall 1 ppb bezogen auf den gesamten Verfahrweg oder Rotationsbereich nicht überschreitet.

Vorzugsweise wird eine erfindungsgemäße Feinpositioniervorrichtung einen absoluten Positionierfehler kleiner 5 Mikrometer, bevorzugt kleiner 1 Mikrometer, besonders bevorzugt kleiner 100 nm, ganz besonders bevorzugt kleiner 10 nm, im Optimalfall kleiner 5 nm, im Idealfall kleiner 1 nm besitzen.

Vorliegende Vorrichtung sowie dazugehörende Verfahren weisen mindestens zwei Positioniervorrichtungen höchster Genauigkeit und Reproduzierbarkeit auf. Für die Qualität der Ausrichtung der Substrate kann ein Konzept der gegenseitigen Fehlerkorrekturen verwendet werden. So kann ein bekannter Versatz (Verdrehung und/oder Verschiebung) eines Substrats und dazu korrespondierend der Positioniervorrichtung mit der Justierung und Korrektur der Position des anderen Positioniervorrichtung und des anderen Substrats mit Korrekturwerten bzw. Korrekturvektoren die Ausrichtungsgenauigkeit erhöht werden. Dabei ist es eine Frage der Größe und Art der Verdrehung und/oder Verschiebung, wie die Steuerung bzw. Regelung Grob- und Feinpositionierung oder nur Grob- oder nur Feinpositionierung zur Fehlerkorrektur einsetzt.

Im weiteren Text werden Positioniervorrichtungen (Grob- oder Fein- oder zusammengesetzte Positioniervorrichtungen) sowie Ausrichtungsmittel als Synonyme betrachtet und verwendet.

Die Ausrichtung der Substrate zueinander kann erfindungsgemäß in allen sechs Bewegungsfreiheitsgraden erfolgen: drei Translationen gemäß der Koordinatenrichtungen x, y und z sowie drei Rotationen um die Koordinatenrichtungen. Erfindungsgemäß können die Bewegungen in jeglicher Richtung und Orientierung durchgeführt werden. Die Ausrichtung der Substrate beinhaltet insbesondere einen passiven oder aktiven Keilfehlerausgleich, vorzugsweise gemäß der Offenbarung in der Druckschrift EP2612109B1.

Roboter zum Substrathandling werden als Bewegungseinrichtungen subsummiert. Die Festhaltungen können in den Bewegungseinrichtungen bauteilintegriert oder funktionsintegriert sein.

Weiterhin beinhaltet eine erfindungsgemäße Vorrichtung vorzugsweise Regelungssysteme und/oder Auswertungssysteme, insbesondere Rechner, um die beschriebenen Schritte, insbesondere Bewegungsabläufe auszuführen, Korrekturen durchzuführen, Betriebszustände der erfindungsgemäßen Vorrichtung zu analysieren und zu speichern.

Verfahren werden vorzugsweise als Rezepte erstellt und in maschinenlesbarer Form ausgeführt. Rezepte sind optimierte Wertesammlungen von Parametern, die im funktionalen oder verfahrenstechnischen Zusammenhang stehen. Die Nutzung von Rezepten erlaubt es, eine Reproduzierbarkeit von Produktionsabläufen zu gewährleisten.

Weiterhin beinhaltet eine erfindungsgemäße Vorrichtung gemäß einer vorteilhaften Ausführungsform Versorgungs- sowie Hilfs- und/oder Ergänzungssysteme (Druckluft, Vakuum, elektrische Energie, Flüssigkeiten wie Hydraulik, Kühlmittel, Heizmittel, Mittel und/oder Vorrichtungen zur Temperaturstabilisierung, elektromagnetische Abschirmung).

Weiterhin beinhaltet eine erfindungsgemäße Vorrichtung Gestelle, Verkleidungen, schwingungsunterdrückende oder -dämpfende oder - tilgende aktive oder passive Subsysteme.

### Messung

Weiterhin beinhaltet eine erfindungsgemäße Vorrichtung mindestens ein Messsystem, bevorzugt mit Messeinheiten für jede Bewegungsachse, welche insbesondere als Weg-Messsysteme und/oder als Winkel-Messsysteme ausgeführt werden können.

Es können sowohl taktile, also tastende oder nicht-taktile Meßverfahren verwendet werden. Die Meßnormale, die Einheit der Messung kann als physikalisch-körperliches Objekt, insbesondere als ein Maßstab vorliegen oder im Meßverfahren implizit vorhanden sein, wie die Wellenlänge der verwendeten Strahlung vorliegen.

Für das Erreichen der Ausrichtungsgenauigkeit kann mindestens ein Messsystem ausgewählt und verwendet werden. Messsysteme setzen Messverfahren um. Es können insbesondere
- Induktive Verfahren und/oder
- Kapazitive Verfahren und/oder
- Resistive Verfahren und/oder
- Vergleichsverfahren, insbesondere optische Bilderkennungsverfahren und/oder
- inkrementelle oder absolute Verfahren (mit insbesondere Glasnormale als Maßstab, oder Interferometer, insbesondere Laserinterferometer, oder mit magnetischer Normale) und/oder
- Laufzeitmessungen (Dopplerverfahren, time of flight-Verfahren) oder andere Zeiterfassungsverfahren und/oder
- Triangulationsverfahren, insbesondere Lasertriangulation,
- Autofokusverfahren und/oder
- Intensitätsmessverfahren wie faseroptische Entfernungsmesser verwendet werden.

### Zusätzliches Messsystem mit Variationen, Substrathalter

Weiterhin beinhaltet eine besonders bevorzugte Ausführungsform der erfindungsgemäßen Vorrichtung mindestens ein zusätzliches Messsystem, welches die X-Y-Position und/oder Ausrichtungslage und/oder Winkellage mindestens eines der Substrate und/oder eines der Substrathalters im Bezug zu einer definierten Referenz, insbesondere zum Gestell erfasst. Als Gestell kann ein, insbesondere aus Naturhartgestein oder Mineralguss oder Kugelgraphitguss oder hydraulisch gebundenem Beton bestehender, Teil vorgesehen sein, welches insbesondere schwingungsgedämpft und/oder schwingungsisoliert und/oder mit Schwingungstilgung ausgestattet ist.

Erfindungsgemäß können Messwerte insbesondere miteinander kombiniert und/oder zueinander referenziert und/oder korreliert werden, sodass durch eine Messung einer Ausrichtungsmarkierung auf die Position der hierauf bezogenen anderen Ausrichtungsmarkierung geschlossen werden kann.

In einer erfindungsgemäßen Ausführungsform wird die Position eines Substrathalters an einem Punkt (oder Stelle oder Messfleck oder Blickfeld) im Bezug zur Referenz, insbesondere der ersten Ausrichtungsmarkierung am ersten Substrat und/oder der zweiten Ausrichtungsmarkierung am zweiten Substrat, erfasst.

In einer weiteren erfindungsgemäßen Ausführungsform wird die Position eines Substrathalters an genau zwei Punkten im Bezug zur Referenz erfasst.

In einer weiteren erfindungsgemäßen Ausführungsform wird die Position eines Substrathalters an genau drei Punkten im Bezug zur Referenz erfasst und damit die Position und Lage des Substrathalters bestimmt.

Für eine Positionsbestimmung an einem Punkt oder an zwei Punkten oder drei Punkten oder beliebig vielen Punkten können in einer ersten erfindungsgemäßen Ausführungsform optische Mustererkennung mittels Kamerasystemen sowie am Substrathalter angebrachte Muster verwendet werden. Die Muster werden in einem Echtzeitsystem, insbesondere kontinuierlich während der Ausrichtung, erfasst.
Für die Positionsbestimmung können aufgeführte Messverfahren ebenfalls verwendet werden.

Eine Umkehrung ist, insbesondere durch Anbringung der Erfassungseinheiten auf dem Substrathalter und Anbringung von Ausrichtungsmarkierungen am Gestell erfindungsgemäß denkbar.

Damit eine Erfassung, Auswertung und Steuerung zu einem beliebigen Zeitpunkt, insbesondere dauerhaft, erfolgen kann, werden die Muster gemäß einer vorteilhaften Ausführungsform auf einer größeren Fläche als das Blickfeld eines Bilderfassungssystems der Erfassungseinheiten verteilt, um die Steuereinheit (und/oder Regeleinheit), insbesondere kontinuierlich, mit Messwerten zu versorgen.

In einer weiteren erfindungsgemäßen Ausführungsform der Vorrichtung weist mindestens einer der Substrathalter eine Durchgangsöffnung zur Erfassung der Ausrichtungsmarkierungen von der Auflageseite der Substrate her auf.

Erfindungsgemäß vorteilhaft ist es, wenn mindestens eines der Substrate mindestens eine Ausrichtungsmarkierung auf der zu bondenden Oberfläche (Kontaktfläche) und mindestens eine Ausrichtungsmarkierung auf der gegenüberliegenden Oberfläche (Auflagefläche) aufweist.

Die Ausrichtungsmarkierung sind vorzugsweise mehrere an der Auflagefläche mindestens eines der Substrate, insbesondere eineindeutig zuordenbar, vorzugsweise gleichmäßig, verteilte Ausrichtungsmarken. Die Ausrichtungsmarkierung an der Auflagefläche ist zumindest in Bezug auf ihre X-Y-Position und/oder Ausrichtungslage mit der X-Y-Position und/oder Ausrichtungslage der Ausrichtungsmarkierung desselben Substrates korrelierbar. Dies ermöglicht eine kontinuierliche Positionsbestimmung während des Ladens und der Ausrichtung der Substrate bis zur Kontaktierung der Substrate.

In einer Weiterbildung der vorliegenden Erfindung sind die Ausrichtungsmarken der Auflagefläche bis auf eine Randzone (edge exclusion zone) des Substrats, insbesondere gleichmäßig, verteilt.

In einer weiteren Ausführungsform mindestens eines der Substrate sind die Ausrichtungsmarken der Auflagefläche eineindeutig zur Kontaktfläche desselben Substrats und der auf der Kontaktfläche angeordneten Ausrichtungsmarkierung verteilt.

Für eine X-Y-Positionsbestimmung an mindestens einem Punkt kann in einer weiteren erfindungsgemäßen Ausführungsform mindestens ein Interferometer mit einem entsprechend ausgebildeten, insbesondere monolithischen, Reflektor für die Erfassung der X-Y-Position- und/oder Lagebestimmung des Substrathalters verwendet werden. Die Anzahl der Interferometer ist insbesondere gleich der Anzahl der Reflexionsflächen des Reflektors.

Der, insbesondere aus einem monolithischen Block gebildete, Substrathalter weist vorzugsweise mindestens zwei der folgenden Funktionen auf:
- Substratbefestigung mittels Vakuum (Vakuumbahnen, Anschlüsse),
- Formkompensation zur Verformung des Substrats mittels mechanischen und/oder hydraulischen und/oder piezoelektronischen und/oder pyroelektrischen und/oder elektrothermischen Betätigungselementen, bevorzugt insbesondere gemäß den Ausführungsformen EP2656378B1, WO2014191033A1 offenbart.
- Positions- und/oder Lagebestimmung (Messnormalen, Reflexionsflächen und/oder Prismen, insbesondere die Reflektoren für die Interferometrie, Passmarken und/oder Passmarkenfelder, flächenhaft ausgebildete Messnormalen für Ebenen, Volumennormalen, insbesondere Stufen)
- Bewegung (Führungsbahnen)

Erfindungsgemäße Bewegungseinrichtungen, die nicht zur Feinjustierung verwendet werden, sind insbesondere als Robotersysteme, vorzugsweise mit inkrementellen Weggebern, ausgebildet. Die Genauigkeit dieser Bewegungseinrichtungen für Hilfsbewegungen wird von der Genauigkeit zur Ausrichtung des Substratstapels entkoppelt. sodass die Hilfsbewegungen mit niedriger Wiederholungsgenauigkeit von kleiner 1 mm, bevorzugt kleiner 500 Mikrometer, besonders bevorzugt kleiner 150 Mikrometer ausgeführt werden.

Die Steuerung und/oder Regelung von erfindungsgemäßen Bewegungseinrichtungen zur (lateralen) Ausrichtung (Feinjustierung) wird insbesondere auf Basis von mit anderen Messmittel erfassten X-Y-Positionen und/oder Ausrichtungslagen durchgeführt. Die Genauigkeit dieser Bewegungseinrichtungen ist vorzugsweise kleiner 200 nm, bevorzugt kleiner 100 nm, besonders bevorzugt kleiner 50 nm, ganz besonders bevorzugt kleiner 20 nm, im optimalen Fall kleiner 10 nm, im Idealfall kleiner 1 nm.

### Verfahren

Eine erste Ausführungsform eines erfindungsgemäßen Ausrichtungsverfahrens umfasst folgende, insbesondere zumindest teilweise sequentiellen und/oder gleichzeitigen, Schritte, insbesondere folgenden Ablauf:
Erster Verfahrensschritt: Das erste/untere Substrat wird mit einer Auflagefläche auf den ersten/unteren Substrathalter geladen, wobei auf der gegenüberliegenden Seite (Kontaktseite) eine erste Ausrichtungsmarkierung vorgesehen (vorhanden) ist.

Zweiter Verfahrensschritt: Das erste/untere Substrat wird mit dem Substrathalter ins Blickfeld einer Erfassungsposition einer ersten/oberen Erfassungseinheit des optischen Systems gefahren, insbesondere unter Verwendung von Bewegungseinrichtungen zur Grobjustierung.

Dritter Verfahrensschritt: Das optische System fährt zur Erfassungsposition, soweit dies nicht schon durch den zweiten Verfahrensschritt erledigt ist. Optional kann eine Selbstkalibrierung des optischen Systems bereits jetzt oder vor der Initiierung der Bewegung zur Erfassungsposition erfolgen.

Vierter Verfahrensschritt: Die erste/obere Erfassungseinheit wird auf das zu erkennende Muster der ersten Ausrichtungsmarkierung fokussiert, welches auf der zu bondenden Kontaktfläche des Substrates angeordnet ist. Optional kann das optische System die zweite/untere Erfassungseinheit auf die Fokusebene der ersten/oberen Erfassungseinheit justieren.

Fünfter Verfahrensschritt: Erfassung der ersten Ausrichtungsmarkierung, insbesondere mittels Mustererkennung. Zeitgleich, insbesondere durch Synchronisierung mit der ersten Erfassungseinheit, wird durch ein erfindungsgemäßes zusätzliches Messsystem (mit dritter Erfassungseinheit) die X-Y-Position und/oder Ausrichtungslage des ersten Substrathalters und/oder des ersten Substrats, vorzugsweise an einer anderen als der Kontaktfläche, erfasst.

Sechster Verfahrensschritt: Klemmung, insbesondere mechanisch und/oder elektronisch und/oder magnetisch, der Position des optischen Systems, insbesondere durch Reduzierung aller Freiheitsgrade auf null.

Siebter Verfahrensschritt: Das optische System justiert die zweite/untere Erfassungseinheit auf die Fokusebene der ersten/oberen Erfassungseinheit.

Optional wurde die Justierung im Folge des vierten Verfahrensschrittes durchgeführt und entfällt.

Achter Verfahrensschritt: Ein Regelungs- und Auswertungsrechner (insbesondere in der Steuerungseinheit) führt Abstraktionen und/oder Berechnungen durch, um Messergebnisse zur Steuerung der Ausrichtung zu erhalten: Der Regelungs- und Auswertungsrechner stellt insbesondere eine Korrelation der Messergebnisse des optischen Systems und des zusätzlichen (dritten) Messsystems her und speichert die Ergebnisse, insbesondere als ein Sollwert der X-Y-Position und/oder Ausrichtungslage des ersten/unteren Substrathalters sowie des ersten/unteren Substrats.

Neunter Verfahrensschritt: Der erste/untere Substrathalter wird aus dem Blickfeld (Strahlengang zur Erfassung) des optischen Systems gefahren. Somit wird eine Blockierung des optischen Pfades für die erste Erfassungseinheit aufgehoben. Das optische System bleibt vorzugsweise weiterhin fixiert.

Zehnter Verfahrensschritt: Das zweite/obere Substrat wird auf den zweiten/oberen Substrathalter geladen. Dieser Verfahrensschritt kann bereits vor einem der vorherigen Verfahrensschritte durchgeführt werden.

Elfter Verfahrensschritt: Der zweite/obere Substrathalter fährt mit dem zweiten/oberen Substrat ins Blickfeld des optischen Systems.

Zwölfter Verfahrensschritt: Die zweite/untere Erfassungseinheit des optischen Systems sucht und erfasst analog zur ersten/oberen Erfassungseinheit die Ausrichtungsmarkierung am zweiten/oberen Substrat. Dabei wird das optische System mechanisch nicht bewegt, es ist jedoch eine Korrektur der Fokussierung denkbar. Bevorzugt wird jedoch auch keine Fokussierbewegung durchgeführt.

Dreizehnter Verfahrensschritt: Das zweite/obere Substrat sowie der zweite/obere Substrathalter blockieren den optischen Pfad der ersten/oberen Erfassungseinheit, sodass keine direkte Beobachtbarkeit/Erfassung der zu bondenden Kontaktfläche des ersten/unteren Substrats in der ausgerichteten Position möglich ist.

Vierzehnter Verfahrensschritt: Der Regelungs- und Auswertungsrechner ermittelt die Ausrichtungsfehler, wobei auf die Offenbarungen in den Druckschriften US6214692B1, WO2014202106A1 Bezug genommen wird. Aus dem Ausrichtungsfehler wird insbesondere ein Ausrichtungsfehlervektor erstellt. Darauffolgend wird insbesondere mindestens ein Korrekturvektor errechnet. Der Korrekturvektor kann dem Ausrichtungsfehlervektor paralleler, ihm entgegengesetzter Vektor sein, sodass die Summe des Ausrichtungsfehlervektors und des Korrekturvektors Null ergibt. In Sonderfällen können weitere Parameter in die Berechnung des Korrekturvektors berücksichtigt werden, sodass das Ergebnis von Null unterschiedlich ist.

Fünfzehnter Verfahrensschritt: Die X-Y-Position und/oder Ausrichtungslage des zweiten/oberen Substrats (mitsamt Substrathalter) wird gemäß Korrekturvektor eingestellt und anschließend geklemmt, sodass der berechnete Ausrichtungsfehler mindestens minimiert, bevorzugt eliminiert wird.

Sechzehnter Verfahrensschritt: Nachdem die Klemmung/Fixierung des zweiten/oberen Substrats erfolgt ist, wird mit der zweiten/unteren Erfassungseinheit die X-Y-Position des zweiten oberen Substrats nochmals erfasst/überprüft. Somit können Verschiebungen und/oder Verdrehungen, welche durch die Klemmung hervorgerufen waren, erkannt und mit Iteration des zwölften bis fünfzehnten Verfahrensschrittes minimiert, insbesondere eliminiert werden.

Alternativ können die detektierten Verschiebungen und/oder Verdrehungen zur Erstellung von Korrekturwerten und/oder Korrekturvektoren berücksichtigt werden, sodass eine Eliminierung in den folgenden Verfahrensschritten berücksichtigt werden kann. Die Korrekturwerte für Verschiebungen sind vorzugsweise kleiner 5 Mikrometer, bevorzugt kleiner 1 Mikrometer, besonders bevorzugt kleiner 100 Nanometer, ganz besonders bevorzugt kleiner 10 Nanometer, im optimalen Fall kleiner 5 Nanometer, im Idealfall kleiner 1 Nanometer. Die Korrekturwerte für Verdrehungen sind insbesondere kleiner 50 Mikroradiant, bevorzugt kleiner 10 Mikroradiant, besonders bevorzugt kleiner 5 Mikroradiant, ganz besonders bevorzugt kleiner 1 Mikroradiant, im optimalen Fall kleiner 0,1 Mikroradiant, im Idealfall kleiner 0,05 Mikroradiant.

Im fünfzehnten Verfahrensschritt kann in Analogie zum zwölften Verfahrensschritt mindestens eine Messung der Position vor- sowie mindestens eine Messung nach der Fixierung des oberen Substrats erfolgen. Eine iterative Korrektur der Fehler ist erfindungsgemäß denkbar, sodass die nächsten Verfahrensschritte erst nach Erreichen einer definierten Genauigkeitsanforderung (Schwellenwert) durchgeführt werden.

Sechzehnter Verfahrensschritt: Der erste/untere Substrathalter fährt in die bereits erfasste Position und Lage des Sollwertes (siehe achter Verfahrensschritt) zurück. Dabei wird die X-Y-Position und Ausrichtungslage des unteren Substrathalters (samt Substrat) mit dem zusätzlichen Messsystem, insbesondere in Echtzeit, kontrolliert. Die Beobachtbarkeit der ersten Ausrichtungsmarkierung des ersten Substrats ist nicht gegeben, da der geklemmte obere Substrathalter den optischen Pfad blockiert.

Siebzehnter Verfahrensschritt: Die tatsächliche X-Y-Position und Ausrichtungslage des ersten/unteren Substrathalters wird so lange korrigiert, bis die Differenz zum Sollwert null ist, zumindest aber einen definierten Schwellenwert nicht überschreitet.

Achtzehnter, optionaler Verfahrensschritt: Die Substrate werden gefügt, wobei auf die Offenbarung der Druckschrift WO2014191033A1 Bezug genommen wird.

Neunzehnter Verfahrensschritt: Der Substratstapel wird aus der Vorrichtung entladen.

Eine zweite, alternative Ausführungsform des erfindungsgemäßen Ausrichtungsverfahrens umfasst folgende Änderungen der Beladesequenzen für das obere und untere Substrat gegenüber der ersten Ausführungsform:
Als erster erfindungsgemäßer Verfahrensschritt wird das erste/untere Substrat auf dem ersten/unteren Substrathalter geladen.

Als zweiter erfindungsgemäßer Verfahrensschritt wird das zweite/obere Substrat auf den zweiten/oberen Substrathalter geladen.

Weiterhin gelten die Verfahrensschritte der ersten Ausführungsform analog.

In einer dritten Ausführungsform des erfindungsgemäßen Verfahrens wird das erste und/oder zweite Verfahren insoweit geändert, dass sowohl in der erfindungsgemäßen Vorrichtung als auch im Verfahren die Richtungen oben und unten vertauscht werden. So wird insbesondere der obere Substrathalter mit mindestens einem zusätzlichen Messsystem beobachtet.

In einer vierten Ausführungsform des erfindungsgemäßen Verfahrens werden die aufgeführten Verfahren insoweit geändert, dass die Ladereihenfolge der Substrate bei gleichbleibendem Verfahrensergebnis vertauscht wird.

In einer fünften Ausführungsform des erfindungsgemäßen Verfahrens wird durch Parallelisierung der Verfahrensschritte eine Beschleunigung erreicht, insbesondere wird während eines Mustererkennungsschrittes am ersten Substrat bereits die Beladung des zweiten Substrates durchgeführt.

In einer sechsten Ausführungsform des erfindungsgemäßen Verfahrens und dazugehörigen Vorrichtung können die zusätzlichen Messsysteme die Position und/oder Lage sowohl des oberen als auch des unteren Substrathalters und/oder des oberen als auch des unteren Substrats erfassen.

In einer siebten Ausführungsform des erfindungsgemäßen Verfahrens und dazugehörigen Vorrichtung können die zusätzlichen Messsysteme die Position und/oder Lage des oberen Substrathalters und/oder des oberen Substrats erfassen.

Es werden alle technisch möglichen Kombinationen und/oder Permutationen sowie Vervielfachungen der funktionellen und/oder materiellen Teile der Vorrichtung und die damit einhergehenden Veränderungen in mindestens einem der Verfahrensschritte oder Verfahren als offenbart betrachtet.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische Querschnittsdarstellung einer Ausführungsform der erfindungsgemäßen Vorrichtung,
- Figur 2a: eine schematische, vergrößerte Querschnittsdarstellung der Ausführungsform gemäß Figur 1a in einem ersten Verfahrensschritt,
- Figur 2b: eine schematische, vergrößerte Querschnittsdarstellung der Ausführungsform gemäß Figur 1a in einem zweiten Verfahrensschritt,
- Figur 2c: eine schematische, vergrößerte Querschnittsdarstellung der Ausführungsform gemäß Figur 1a in einem dritten Verfahrensschritt,

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

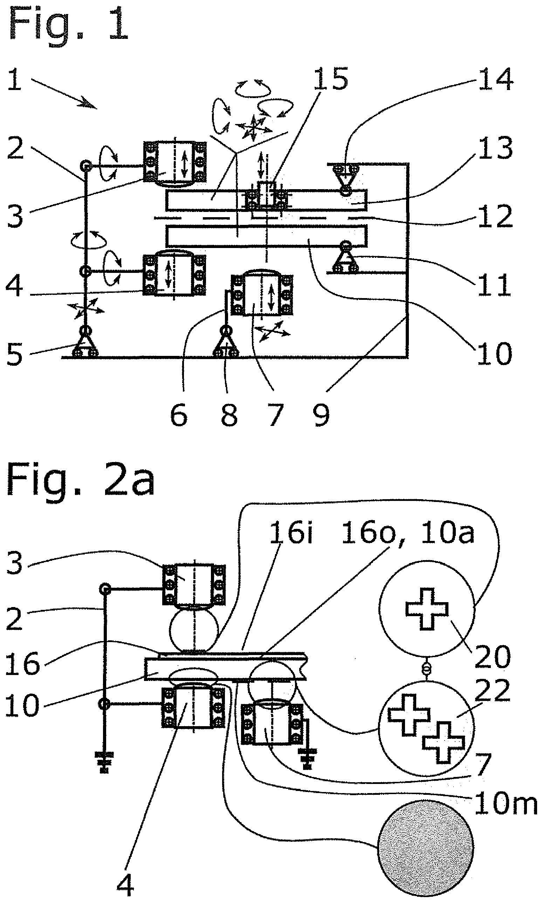

Fig. 1 ist eine schematische, nicht maßstabgetreue Funktionaldarstellung der Hauptkomponenten einer ersten Ausführungsform einer Ausrichtungsanlage 1 abgebildet. Die Ausrichtungsanlage 1 ist in der Lage, in der Figur 1 nicht eingezeichnete Substrate 16 (als erstes und/oder unteres Substrat bezeichnet), 17 (als zweites und/oder oberes Substrat bezeichnet) und/oder Substratstapel zueinander auszurichten und miteinander zumindest teilweise und/oder vorläufig (sogenannter Pre-Bond) zu verbinden. Mögliche Bewegungen/Freiheitsgrade der nachfolgend beschriebenen funktionalen Bauteile werden als Pfeile symbolisch dargestellt.

Das erste Substrat 16 wird auf einen ersten Substrathalter 10 geladen und ist auf diesem ohne verbleibende Freiheitsgrade des Substrats 16 gegenüber dem ersten Substrathalter 10 fixierbar. Das zweite Substrat 17 wird auf einen zweiten Substrathalter 13 geladen und ist auf diesem ohne verbleibende Freiheitsgrade des Substrats 16 gegenüber dem zweiten Substrathalter 13 fixierbar.

Der erste, insbesondere untere, Substrathalter 10 ist an einer ersten Bewegungseinrichtung 11 zur Halterung und Umsetzung von Zuführ- sowie Justierbewegungen (Ausrichtung) des ersten Substrathalters 10 angeordnet. Der zweite, insbesondere obere, Substrathalter 13 ist an einer zweiten Bewegungseinrichtung 14 zur Halterung und Umsetzung von Zuführ- sowie Justierbewegungen (Ausrichtung) des zweiten Substrathalters 13 angeordnet. Die Bewegungseinrichtungen 11, 14 sind insbesondere an einem gemeinsamen, massiven Tisch oder Gestell 9 fixiert, um Schwingungen aller funktionalen Bauteile zu reduzieren/minimieren.

Zur Beobachtung (Erfassung) einer ersten Ausrichtungsmarkierung 20 und einer zweiten Ausrichtungsmarkierung 21 ist ein optisches System 2 bestehend aus:
- einer ersten Erfassungseinheit 3, insbesondere einem Bilderfassungsmittel, zur Erfassung der ersten Ausrichtungsmarkierung 20 am ersten Substrat 16 und
- einer zweiten Erfassungseinheit 4, insbesondere einem Bilderfassungsmittel, zur Erfassung der zweiten Ausrichtungsmarkierung am zweiten Substrat 17.

Das optische System 2 ist auf eine, vorzugsweise gemeinsame, Fokusebene 12 fokussierbar, die zwischen dem ersten und zweiten Substrat 16, 17 verortet wird, wenn diese zur Ausrichtung angeordnet sind. Bewegungen des optischen Systems 2, insbesondere in X-, Y- und Z-Richtung, werden mittels einer Positioniervorrichtung 5 zur Positionierung des optischen Systems 2 durchgeführt. Die Positioniervorrichtung 5 ist insbesondere an dem massiven Tisch oder Gestell fixiert.
In einer besonders bevorzugten, nicht dargestellten Ausführungsform wird das gesamte optische System 2 (mit Positioniermittel 5, Erfassungseinheiten 3 sowie 4, etc.) in zweifacher, spiegelsymmetrischer Ausführung verwendet.

Mindestens ein zusätzliches, insbesondere optisches, Messsystem 6 mit mindestens einer dritten Erfassungseinheit 7 des zusätzlichen Messsystems 6 wird für die erfindungsgemäße Erhöhung der Ausrichtungsgenauigkeit durch Erfassung einer dritten Ausrichtungsmarkierung 22 verwendet. Eine Bewegung des zusätzlichen Messsystems wird mit einer Positioniereinrichtung 8 ausgeführt.

Soweit es sich um ein optisches Messsystem 6 handelt, kann die Positioniereinrichtung 8 eine Fokussierung in Bezug auf die dritte Ausrichtungsmarkierung 22 durch Bewegung der dritten Erfassungseinheit 7 in Z-Richtung vornehmen. Eine Positionierung in X-Y-Richtung ist ebenfalls denkbar, wobei während der Ausrichtung insbesondere eine Fixierung des Messsystems 6, vorzugsweise an dem Tisch/Gestell, erfolgt. Alternativ muss die exakte X-Y-Position des Messsystems 8 bekannt sein.

In der dargestellten erfindungsgemäßen Ausführungsform der Ausrichtungsanlage 1 wird mit dem zusätzlichen Messsystem 6 insbesondere die X-Y-Position und/oder Lage (insbesondere auch die Rotationslage) des unteren Substrathalters 10 mit besonders hoher Genauigkeit erfasst.

In einer nicht dargestellten weiteren, erfindungsgemäßen Ausführungsform der Ausrichtungsanlage 1 wird mit dem zusätzlichen Messsystem insbesondere die Position und/oder Lage des oberen Substrathalters mit besonders hoher Genauigkeit erfasst.

In einer nicht dargestellten weiteren erfindungsgemäßen Ausführungsform der Ausrichtungsanlage 1 werden mit zusätzlichen Messsystemen insbesondere die Positionen und/oder Lagen des oberen Substrathalters und unteren Substrathalters mit besonders hoher Genauigkeit erfasst.

In einer nicht dargestellten weiteren erfindungsgemäßen Ausführungsform der Ausrichtungsanlage wird mit mindestens einem Messsystem insbesondere die Position und/oder Lage mindestens eines der Substrate mit besonders hoher Genauigkeit erfasst. Dazu werden die Ausrichtungsmarkierungen auf der Kontaktfläche sowie Markierungen auf der zur Kontaktfläche abgewandten Seite erfasst.

Fig. 2a zeigt eine schematische Darstellung eines erfindungsgemäßen Verfahrensschritts der Zuordnung von Messwerten mindestens zweier Erfassungseinheiten, insbesondere zweier Erfassungseinheiten zur Erfassung mindestens zweier X-Y-Positionen von auf unterschiedlichen Seiten des ersten Substrats 16 und/oder des ersten Substrathalters 10 angeordneten Ausrichtungsmarkierungen 20, 22 zueinander.

Auf einer ersten Fixierfläche 10a des ersten Substrathalters 10 wird das erste/untere Substrat 16 befestigt. Als Befestigung wird insbesondere eine mechanische und/oder elektrostatische Klemmung, Anpresskraft, welche wegen einer Druckdifferenz zwischen Umgebung in Normalatmosphäre und Unterdruck am ersten Substrathalter 10 erzeugt wird, auch als Vakuumfixierung genannt, verwendet. Die Befestigung erfolgt insbesondere so, dass das erste Substrat 16 während des gesamten erfindungsgemäßen Verfahrens relativ zum ersten Substrathalter 10 keine parasitäre oder unerwünschte Bewegung erfährt; es kann insbesondere eine thermische Wärmedehnung unterbunden oder reduziert werden, soweit der erste Substrathalter 10 und das erste Substrat 16 jeweils einen korrespondierenden, vorzugsweise linear korrespondierend verlaufenden, Wärmedehnungskoeffizienten besitzen, wobei der Unterschied der Wärmedehnungskoeffizienten und/oder des linearen Verlaufs der Wärmedehnungskoeffizienten vorzugsweise weniger als 5%, bevorzugt weniger 3%, besonders bevorzugt weniger 1%, beträgt.

Bevorzugt wird die Anlage in einer temperaturstabilisierten Umgebung, insbesondere in einem Reinraum, betrieben, in welcher eine Temperaturschwankung kleiner 0,5 Kelvin, bevorzugt kleiner 0,1 Kelvin, besonders bevorzugt 0,05 Kelvin, im Optimalfall kleiner 0,01 Kelvin während eines Ausrichtungszyklus einhaltbar ist.

Das befestigte erste Substrat 16 und der erste Substrathalter 10 können als quasi-monolithischer Körper für die Ausführung der Bewegungen des ersten Substrats 16 verstanden werden, welche keine Relativbewegungen zueinander erlauben.

Diese Substratbefestigung kann formschlüssig und/oder bevorzugt kraftschlüssig erfolgen. Eine quasi-monolithische Verbindung führt dazu, dass Einflüsse, welche zwischen dem Substrathalter und Substrat eine Verschiebung und/oder Verdrehung und/oder Deformation bewirken können, mindestens reduziert, bevorzugt mindestens um eine Größenordnung reduziert, besonders bevorzugt eliminiert werden.
Die Einflüsse können thermisch, und/oder mechanisch, und/oder strömungsbedingt und/oder materieller Art (Partikel) sein.

Mit Formschluss oder Kraftschluss kann das Substrat mit dem Substrathalter so verbunden werden, dass insbesondere die Differenz einer thermischen Dehnung unterdrückt werden kann. Weiterhin kann mit dem Substrathalter die eigenständige Deformation des Substrates reduziert, eliminiert und/oder korrigiert werden, wobei auf die Offenbarung der EP2656378B1 Bezug genommen wird.

Der erste Substrathalter 10 befindet sich während der Erfassung der ersten Ausrichtungsmarkierung 20 in einem optischen Pfad der ersten (oberen) Erfassungseinheit 3. Die erste Ausrichtungsmarkierung 20 wird auf der zu bondenden Kontaktfläche 16i des ersten Substrats 16 im Blickfeld, insbesondere im optischen Pfad, der ersten (oberen) Erfassungseinheit 3 angeordnet. Die erste Erfassungseinheit 3 erzeugt ein, insbesondere digitales, Bild, welches hier schematisch als Ausrichtungsmarke in Form eines Kreuzes dargestellt ist. Die erste Ausrichtungsmarkierung 20 kann auch aus mehreren Ausrichtungsmarkierungen bestehen. Aus dem Bild der Ausrichtungsmarke wird ein Messwert erzeugt/berechnet, welcher insbesondere die X-Y-Position und/oder Ausrichtungslage (insbesondere in Rotationsrichtung um eine Z-Richtung), also den Ausrichtungszustand des ersten Substrates 16 charakterisiert.

Während der Erfassung der ersten Ausrichtungsmarkierung 20 liefert die zweite/untere Erfassungseinheit 4 vorzugsweise keinen Messwert, insbesondere da das zweite Substrat 17 außerhalb des optischen Pfads der ersten Erfassungseinheit 3 angeordnet ist/wurde.

Der erste/untere Substrathalter 10 und/oder das erste/untere Substrat 16 weisen die dritte Ausrichtungsmarkierung 22 auf, an Hand der die X-Y-Position und/oder Ausrichtungslage (insbesondere in Rotationsrichtung um eine Z-Richtung), also der Ausrichtungszustand des Substrathalters 10 und/oder des ersten Substrats (16), insbesondere aus einer anderen Richtung, vorzugsweise einer diametral zur ersten Erfassung in Z-Richtung gegenüberliegenden Richtung, erfasst werden.

Vorzugsweise ist eine Relativbewegung der ersten Erfassungseinheit 3 zur dritten Erfassungseinheit 7 messbar, noch bevorzugter wird von der Erfassung der ersten Ausrichtungsmarkierung 20 und der dritten Ausrichtungsmarkierung 22 bis zur Kontaktierung des ersten und zweiten Substrates 16, 17 keine Relativbewegung zwischen der ersten Erfassungseinheit 3 und der dritten Erfassungseinheit 7 ausgeführt.

Die dritte (zusätzliche) Erfassungseinheit 7 des zusätzlichen Messsystems 6 liefert aus der Vermessung der dritten Ausrichtungsmarkierung 22 des ersten/unteren Substrathalters 10 einen Messwert der X-Y-Position und/oder Lage des ersten/unteren Substrathalters 10. Der Messwert wird insbesondere aus einem, vorzugsweise digitalen, Bild erzeugt, welches symbolisch als Kreuz dargestellt ist. Die dritte Ausrichtungsmarkierung 22 kann auch aus mehreren Ausrichtungsmarkierungen bestehen.

Die beiden Messwerte (X-Y-Position und/oder Ausrichtungslage der ersten Ausrichtungsmarkierung 20 des ersten Substrats 16 sowie X-Y-Position und/oder Ausrichtungslage der dritten Ausrichtungsmarkierung 22 des ersten Substrathalters 10 oder des ersten Substrats 16) werden einander zugeordnet und/oder miteinander korreliert, so dass die X-Y-Position und/oder Ausrichtungslage der ersten Ausrichtungsmarkierung 20 jederzeit an Hand der X-Y-Position und/oder Ausrichtungslage, insbesondere durch Erfassung der X-Y-Position und/oder Ausrichtungslage, der dritten Ausrichtungsmarkierung ein-eindeutig zuordenbar ist.

Durch diesen Verfahrensschritt wird eine Ausrichtung ohne direkte Erfassung der X-Y-Positionen und/oder Ausrichtungslagen der ersten Ausrichtungsmarkierung 20 und/oder der zweiten Ausrichtungsmarkierung 21 während der Ausrichtung und/oder Kontaktierung des ersten Substrats 16 mit dem zweiten Substrat 17 realisierbar. Weiterhin kann der Abstand zwischen den Substraten während der Ausrichtung, minimiert werden. Der Abstand kann vorzugsweise bereits dem Abstand der Substrate während der Erfassung der ersten und zweiten Ausrichtungsmarkierungen entsprechen.

Mit anderen Worten wird insbesondere ein hindernisfreier optischer Pfad zwischen dem Substrathalter 10 und des zusätzlichen Messsystem 6 bereitgestellt, mit welchem die Ausrichtung der Substrate in einem Regelkreis betrieben werden kann oder betrieben wird. Durch diesen Verfahrensschritt kann die X-Y-Position und/oder Ausrichtungslage des ersten Substrathalters 10 und somit des auf dem ersten Substrathalter 10 fixierten ersten Substrates genau bestimmt und reproduzierbar wiederhergestellt werden.

Die Wiederherstellung der X-Y-Position und/oder Ausrichtungslage insbesondere des Substrathalters 10 und insbesondere damit monolithisch verbundenem Substrats stellt einen, insbesondere eigenständigen, Kernaspekt dar. Die Verfahrensschritte dazu wurden bereits an anderer Stelle diskutiert.

Insbesondere wird eine Wiederholungsgenauigkeit der Positionierung (gemessen als relativer Ausrichtungsfehler zwischen den zwei Substraten), auch als Umkehrspiel bekannt, unter 1 Mikrometer, bevorzugt unter 100 nm, besonders bevorzugt unter 30 nm, ganz besonders bevorzugt unter 10 nm, im optimalen Fall unter 5 nm, im Idealfall unter 1 nm erreicht. Das Umkehrspiel kann auch das wiederholte Anfahren einer gegebenen Position mit Hilfe der Bewegungseinrichtungen 11, 14 und/oder 5, 8 sein. Das Umkehrspiel resultiert aus den Bewegungen der Bewegungseinrichtungen, lediglich der Erfassungsort variiert, sodass die Messgröße als relativer Ausrichtungsfehler existiert. Eine Positionierungenauigkeit einer Bewegungseinrichtung, welche keine Wirkung auf die Substrate besitzt, kann als nicht relevantes Umkehrspiel aufgefasst werden.

Es ist erfindungsgemäß zur weiteren Erhöhung der Ausrichtungsgenauigkeit bevorzugt, die erste Erfassungseinheit 3 mit der zweiten Erfassungseinheit 7 zeitsynchronisiert zu betreiben, insbesondere mit einem Zeitunterschied der Erfassungen der Messwerte von unter 1 Zehntelsekunde, bevorzugt unter 1 Millisekunde, besonders bevorzugt unter 10 Mikrosekunden, ganz besonders bevorzugt unter 1 Mikrosekunde, im optimalen Fall unter 1 ns, im Idealfall 0,0 ns. Dies ist besonders vorteilhaft, weil die Wirkung von Störeinflüssen wie mechanische Schwingungen eliminiert werden kann. Mechanische Schwingungen breiten sich unter anderem mit Körperschall mit einigen Tausend m/s in den Werkstoffen aus. Falls eine Regelung und die Erfassungsmittel schneller arbeiten, als die Ausbreitungsgeschwindigkeit des Körperschalls, wird eine Störung reduziert oder eliminiert.

Ändert eine Störung die Lage des ersten Substrats 16 auf dem ersten Substrathalter 10 so, dass die erste Erfassungseinheit 3 bereits einen Messwert aufgenommen hat und das zusätzliche Messsystem 6 mit der Erfassungseinheit 7 noch keinen Messwert aufgenommen hat, kann die Störung einen Anteil an der Verminderung der Genauigkeit der Ausrichtung bewirken, da in der Zeit zwischen den Messwertaufnahmen der Erfassungsmittel 3 und 7 insbesondere schwingungsbedingte, schnelle mechanische Positionsänderungen in einer Nanometer- oder Mikrometer-Größenordnung erfolgen können. Erfolgt die Messwertaufnahme zeitverzögert (in Größenordnung Sekunden oder Minuten) können weitere Störeinflüsse wie thermisch bedingte Formänderungen oder Längenänderungen ebenfalls die Ausrichtungsgenauigkeit herabsetzen.

Werden die erste Erfassungseinheit 3 und die dritte Erfassungseinheit 7 zueinander synchronisiert (insbesondere durch zeitgleiche Auslösung der Erfassung sowie Ausgleich der Erfassungszeit und/oder gleiche Integrationszeit für Kamerasysteme), können einige Störeinflüsse reduziert, im optimalen Fall eliminiert werden, da die Erfassung zu einem Zeitpunkt erfolgen soll, in dem die Störeinflüsse möglichst minimale Auswirkung auf die Erfassungsgenauigkeit haben.

In einer möglichen Ausführungsform der Anlage kann bei bekannten, insbesondere periodischen, Störeinflüssen, insbesondere zum Scheitelpunkt der Schwingung synchronisiert, die Erfassung erfolgen. Mit Vorzug können dazu im Vorfeld Schwingungssensoren (Beschleunigungssensoren, Interferometer, Vibrometer) an für die Genauigkeit relevanten Stellen der Anlage die Störeinflüsse aufnehmen und zur Eliminierung insbesondere in Recheneinheiten, Computer prozessieren. In einer weiteren Ausführungsform können die Schwingungssensoren an den charakteristischen Stellen der Anlage fest verbaut werden.

In einer weiteren möglichen Ausführungsform kann die Anlage insbesondere eine Kombination aus aktiver und/oder passiver Schwingungsdämpfung, aktiver und/oder passiver Schwingungstilgung und/oder aktiver und/oder passiver Schwingungsisolierung, auch kaskadiert, ausgeführt verwendet werden. Zusätzlich können die Schwingungen als Störeinflüsse mit aufgezwungenen Schwingungen überlagert werden, sodass eine Erfassung der Ausrichtungsmarken in einem sog. Lock-in-Verfahren erfolgen kann. Für die Charakterisierung der Anlage und zur Überprüfung der Schwingungszustände kann Modalanalyse, und/oder FEM verwendet werden. Dies sowie die Auslegung solcher Anlagen sind dem Fachmann bekannt.

Vor oder bei oder nacheiner Erfassung der ersten und dritten Ausrichtungsmarkierungen 20, 22 werden die ersten und dritten Erfassungseinheiten 3, 7 geklemmt, wobei zumindest die absoluten und/oder relativen Freiheitsgrade in X- und Y-Richtung auf null reduziert werden. Mit relativ ist die Bewegung der ersten Erfassungseinheit 3 gegenüber der dritten Erfassungseinheit 7 gemeint.

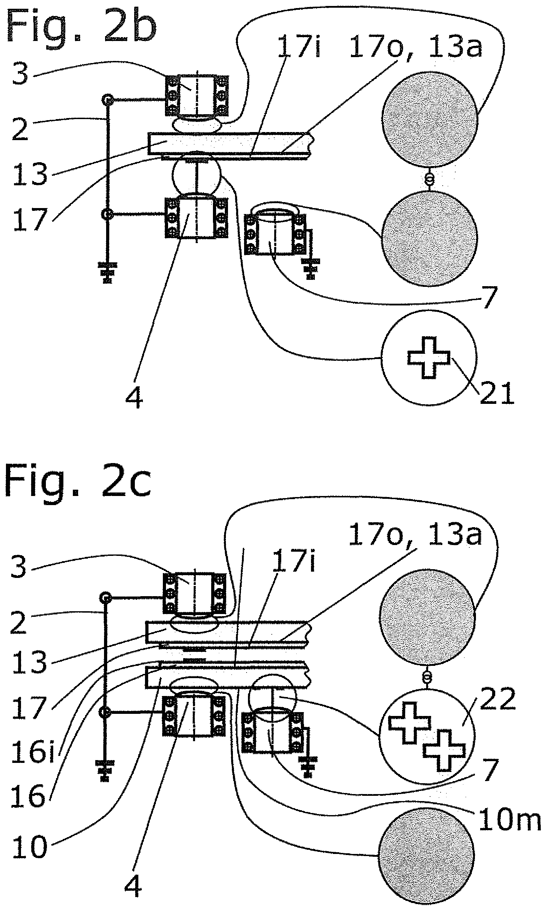

Fig. 2b ist eine schematische Darstellung eines erfindungsgemäßen Verfahrensschritts zur Messwerterfassung des zweiten/oberen Substrats 17. Das optische System 2 ist insbesondere bereits in einem geklemmten Zustand und ein Bild und/oder eine X-Y-Position mindestens einer Ausrichtungsmarke des ersten/unteren Substrats 16 ist gespeichert (nicht dargestellt). Im geklemmten Zustand werden zumindest die absoluten und/oder relativen Freiheitsgrade der zweiten Erfassungseinheit gegenüber der ersten Erfassungseinheit in X- und Y-Richtung auf null reduziert.

Im geklemmten Zustand können die X-Y-Positionen und/oder Ausrichtungslagen der ersten, zweiten und dritten Ausrichtungsmarkierungen auf dasselbe X-Y-Koordinatensystem bezogen werden. Alternativ oder zusätzlich werden die ersten, zweiten und dritten Erfassungseinheiten auf dasselbe X-Y-Koordinatensystem kalibriert.

Das zweite/obere, auf dem zweiten/oberen Substrathalter 13 fixierte Substrat 17 wird mittels der zweiten Bewegungseinrichtung 14 zur Bewegung des zweiten Substrathalters 13 in eine Erfassungsposition gefahren und durch die zweite/untere Erfassungseinheit 4 wird die X-Y-Position und/oder Ausrichtungslage der zweiten Ausrichtungsmarkierung 21 des zweiten Substrats 17 detektiert/erfasst.

Ziel ist eine möglichst perfekte Ausrichtung des zweiten Substrats 17 zur X-Y-Position und/oder Lage des ersten/unteren Substrates 16. Da das untere Substrat 16 ein Hindernis im optischen Pfad zur Betrachtung der zweiten Ausrichtungsmarkierung 21 des zweiten/oberen Substrats 17 durch die zweite Erfassungseinheit 4 wäre, wird das erste/untere Substrat 16 aus dem optischen Pfad herausgefahren, insbesondere durch Bewegung in X- und/oder Y-Richtung, vorzugsweise ohne Bewegung in einer Z-Richtung.

Die Korrektur der X-Y-Position sowie Relativlage beider Substrate wird durch Vergleich der X-Y-Positionen und/oder Ausrichtungslagen der ersten und zweiten Ausrichtungsmarkierung korreliert zur dritten Ausrichtungsmarkierung durchgeführt.

Nachdem der Ausrichtungszustand des zweiten/oberen Substrats mit insbesondere minimalem, bevorzugt eliminiertem Ausrichtungsfehler erreicht wird, wird in diesem Verfahrensschritt der obere Substrathalter geklemmt, also seiner Freiheitsgrade zumindest in X- und Y-Richtung beraubt.

Fig. 2c zeigt eine schematische Darstellung eines erfindungsgemäßen Verfahrensschritts zur Ausrichtung des ersten Substrats 16 gegenüber dem, insbesondere geklemmten, zweiten Substrat 17.

Der optische Pfad des optischen Systems 2 wird zwischen der ersten Erfassungseinheit 3 und der zweiten Erfassungseinheit 4 durch den ersten Substrathalter 10 sowie den zweiten Substrathalter 13 während des Ausrichtens blockiert, sodass die Erfassungseinheiten 3, 4 während der Ausrichtung nicht verwendet werden können.

Das zusätzliche Messsystem 6 mit der dritten Erfassungseinheit 7, welches in einer besonders bevorzugten Ausführungsform ein Kamerasystem mit Mikroskop ist, erzeugt, bevorzugt in Echtzeit, insbesondere kontinuierlich, Bilddaten, welche für eine X-Y-Positions- und/oder Lageregelung als Rohdaten verwendet werden können.

Der (theoretische oder mittlere) Abstand (insbesondere ohne Berücksichtigung einer etwaigen Vorspannung oder Durchhängung) der zu bondenden Kontaktflächen 16i, 17i beträgt insbesondere weniger als 1 mm, bevorzugt weniger als 500 Mikrometer, besonders bevorzugt weniger als 100 Mikrometer, im optimalen Fall weniger als 50 Mikrometer, im Idealfall weniger als 10 Mikrometer. Insbesondere ist der Abstand durch die Bewegungseinrichtungen 11 und/oder 14 einstellbar.

Für die Ausrichtung der Substrate 16 und 17 wird insbesondere ein nach Fig. 2a ermittelter/festgelegter Sollwert verwendet. Der Sollwert beinhaltet insbesondere Bilddaten der dritten Ausrichtungsmarkierung 22 des ersten Substrathalters 10 und/oder die ermittelten X-Y-Positions- und/oder Ausrichtungslagedaten für die Bewegungseinrichtung 11 des ersten Substrathalters 10 und/oder Regelungsparameter wie Bahnkurven zum optimalen Anfahren der X-Y-Position und/oder insbesondere maschinenlesbare Werte für die Antriebe.

In einer weiteren Ausführungsform können Restfehler, die bei der Positionierung des oberen und/oder unteren Substrates nicht eliminiert werden, als Korrekturwerte für die Positionierung des anderen (unteren bzw. oberen) Substrates berücksichtigt werden.

Mittels der ersten Bewegungseinrichtung 11 wird der erste Substrathalter 10 in positions- und insbesondere lagegeregelter Form so lange bewegt, bis der Ausrichtungsfehler, welcher aus dem Sollwert des zusätzlichen Messsystems und der aktuellen Position und/oder Lage des Substrathalters berechnet wird, minimiert, im Idealfall eliminiert ist bzw. ein Abbruchkriterium erreicht wird. Mit anderen Worten wird der untere Substrathalter 10 in kontrollierter, geregelter Weise auf die bereits bekannte, vermessene X-Y-Ausrichtungsposition zurückgefahren.

In weiteren Ausführungsformen können Restfehler, die bei der Positionierung des oberen und/oder unteren Substrates nicht eliminiert werden, ebenfalls als Korrekturwerte für die Positionierung des anderen (unteren bzw. oberen) Substrates berücksichtigt werden.

Weitere Korrekturfaktoren können insbesondere aus dem Schwingungszustand der Anlage oder Anlagenteile wie vorhin beschrieben gewonnen werden, welche für die Positionierung der Substrate angewendet die Restunsicherheit der Positionierung verringern, die Ausrichtungsgenauigkeit erhöhen. Für die Verifikation der finalen Position können nochmals alle bekannten Störfaktoren und Einflüsse berücksichtigt und entsprechend korrigiert werden.

Abschließend werden in diesem erfindungsgemäßen Verfahrensschritt mit der Klemmung aller Antriebe Bewegungen der Substrathalter 10, 13 in einer X-Y-Richtung verhindert.

Nachdem die Substrate 16, 17 gemäß eines der erfindungsgemäßen Verfahren ausgerichtet sind, kann mindestens eines der Substrate mit einer Substratverformungsvorrichtung 15 in Richtung des anderen Substrats verformt werden, um die Substrate mit einem Prebond miteinander zu verbinden.

### Bezugszeichenliste

- 1: Ausrichtungsanlage
- 2: optisches System
- 3: erste/obere Erfassungseinheit
- 4: zweite/untere Erfassungseinheit
- 5: Positioniervorrichtung
- 6: zusätzliches Messsystem
- 7: dritte/zusätzliche Erfassungseinheit
- 8: Positioniervorrichtung des zusätzlichen Messsystems
- 9: Gestell
- 10: erster Substrathalter
- 10a: erste Fixierfläche
- 11: Erste Bewegungseinrichtung
- 12: Gemeinsame theoretische Fokusebene des optischen Systems
- 13: zweiter/oberer Substrathalter
- 13a: zweite Fixierfläche
- 14: Zweite Bewegungseinrichtung
- 15: Substratverformungsvorrichtung
- 16: Unteres Substrat
- 16i: erste Kontaktfläche
- 16o: erste Auflagefläche
- 17: Oberes Substrat
- 17i: zweite Kontaktfläche
- 17o: zweite Auflagefläche
- 20: erste Ausrichtungsmarkierung
- 21: zweite Ausrichtungsmarkierung
- 22: dritte Ausrichtungsmarkierung

## Patentansprüche

1. Verfahren zum Ausrichten und Kontaktieren einer ersten Kontaktfläche (16i) eines ersten Substrats (16) mit einer zweiten Kontaktfläche (17i) eines zweiten Substrats (17) mit folgenden Schritten, insbesondere folgendem Ablauf:
- Fixierung einer ersten Auflagefläche (16o) des ersten Substrats (16) auf einem ersten Substrathalter (10) und einer zweiten Auflagefläche (17o) des zweiten Substrats (17) auf einem zweiten Substrathalter (13), der dem ersten Substrathalter (10) gegenüberliegend anordenbar ist,
- Erfassung einer, insbesondere auf eine Fokusebene (12) einer ersten Erfassungseinheit (3) bezogenen, ersten X-Y-Position und/oder ersten Ausrichtungslage einer, insbesondere in einem Umfangsbereich des ersten Substrats (16) angeordneten, ersten Ausrichtungsmarkierung (20),
- Erfassung einer, insbesondere auf eine Fokusebene (12) einer zweiten Erfassungseinheit (4) bezogenen, zweiten X-Y-Position und/oder zweiten Ausrichtungslage einer, insbesondere in einem Umfangsbereich des zweiten Substrats (17) angeordneten, zweiten Ausrichtungsmarkierung (21),
- Ausrichtung des ersten Substrats (16) gegenüber dem zweiten Substrat (17), und
- Kontaktierung des gegenüber dem zweiten Substrat (17) ausgerichteten ersten Substrats (16) mit dem zweiten Substrat (17)
**dadurch gekennzeichnet, dass**
vor der Ausrichtung zusätzlich eine Erfassung einer dritten X-Y-Position und/oder dritten Ausrichtungslage des ersten Substrathalters (10) und/oder des ersten Substrats (16) durch eine dritte Erfassungseinheit (7) erfolgt, mittels der die Ausrichtung gesteuert wird, wobei die erste Ausrichtungsmarkierung (20) und die dritte Ausrichtungsmarkierung (22) auf unterschiedlichen, insbesondere in einer Z-Richtung gegenüberliegenden, Seiten des ersten Substrats (16) oder des ersten Substrathalters (3) angeordnet sind.

2. Verfahren nach Anspruch 1, bei dem die Erfassung der ersten Ausrichtungsmarkierung (20) und der dritten Ausrichtungsmarkierung (22) in einem zusammenhängenden Verfahrensschritt, insbesondere gleichzeitig, vorzugsweise durch Synchronisierung der ersten Erfassungseinheit (3) und dritten Erfassungseinheit (7) erfolgt.

3. Verfahren nach einem der vorhergehenden Ansprüche, wobei der zweite Substrathalter (13) während der Ausrichtung zumindest in X-Y-Richtung fixiert wird.

4. Verfahren nach einem der vorhergehenden Ansprüche, wobei die erste Erfassungseinheit (3) und die zweite Erfassungseinheit (4) an einer gemeinsamen X-Y-Positioniervorrichtung angebracht sind und/oder optische Achsen der ersten Erfassungseinheit (3) und der zweiten Erfassungseinheit (4) zueinander ausgerichtet oder zugeordnet sind, vorzugsweise eine gemeinsame optische Achse aufweisen.

5. Verfahren nach einem der vorhergehenden Ansprüche, wobei die dritte Erfassungseinheit (7) zumindest gegenüber der ersten Erfassungseinheit (3), insbesondere gegenüber einem optischen System (2) aus der der ersten Erfassungseinheit (3) und der zweiten Erfassungseinheit (4), während der Erfassung zumindest bis zur Ausrichtung in X- und Y-Richtung ortsfest angeordnet wird, vorzugsweise keine Freiheitsgrade aufweist.

6. Verfahren nach einem der vorhergehenden Ansprüche, wobei die Steuerung der Ausrichtung ausschließlich mittels der Erfassung der dritten X-Y-Position und/oder dritten Ausrichtungslage erfolgt.

7. Verfahren nach einem der vorhergehenden Ansprüche, wobei das erste Substrat und das zweite Substrat während der Erfassungen und bis zur Ausrichtung zwischen dem ersten Substrathalter und dem zweiten Substrathalter mit einem, insbesondere konstanten, Abstand A zwischen der ersten Kontaktfläche und der zweiten Kontaktfläche in einer Z-Richtung angeordnet sind.

8. Verfahren nach Anspruch 7, wobei der Abstand A weniger als 500 Mikrometer, besonders bevorzugt weniger als 100 Mikrometer, im optimalen Fall weniger als 50 Mikrometer, im Idealfall weniger als 10 Mikrometer, beträgt.

9. Vorrichtung zum Ausrichten und Kontaktieren einer ersten Kontaktfläche (16i) eines ersten Substrats (16) mit einer zweiten Kontaktfläche (17i) eines zweiten Substrats (17) mit:
- einem ersten Substrathalter (10) zur Fixierung einer ersten Auflagefläche (16o) des ersten Substrats (16),
- einem zweiten, dem ersten Substrathalter (10) gegenüberliegend anordenbaren Substrathalter (13) zur Fixierung einer zweiten Auflagefläche (17o) des zweiten Substrats (17),
- einer ersten Erfassungseinheit (3) zur Erfassung einer ersten X-Y-Position und/oder ersten Ausrichtungslage einer ersten Ausrichtungsmarkierung (20),
- einer zweiten Erfassungseinheit (4) zur Erfassung einer zweiten X-Y-Position und/oder zweiten Ausrichtungslage einer zweiten Ausrichtungsmarkierung (21),
- Ausrichtungsmitteln zur Ausrichtung des ersten Substrats (16) gegenüber dem zweiten Substrat (17), und
- Kontaktierungsmitteln (15) zur Kontaktierung des gegenüber dem zweiten Substrat (17) ausgerichteten ersten Substrats (16) mit dem zweiten Substrat (17)
**dadurch gekennzeichnet, dass**
die Vorrichtung eine dritte Erfassungseinheit (7) zur Erfassung einer dritten X-Y-Position und/oder dritten Ausrichtungslage des ersten Substrathalters (10) und/oder des ersten Substrats (16) aufweist, mittels der die Ausrichtung steuerbar ist, wobei die erste Ausrichtungsmarkierung (20) und die dritte Ausrichtungsmarkierung (22) auf unterschiedlichen, insbesondere in einer Z-Richtung gegenüberliegenden, Seiten des ersten Substrats (16) oder des ersten Substrathalters (3) angeordnet sind.

10. Vorrichtung nach Anspruch 9, wobei die erste Erfassungseinheit (3) und die dritte Erfassungseinheit (7) synchronisierbar oder synchronisiert sind.

11. Vorrichtung nach Anspruch 9, wobei der zweite Substrathalter (13) während der Ausrichtung zumindest in X-Y-Richtung fixierbar ausgebildet ist,

12. Vorrichtung nach Anspruch 9, wobei die erste Erfassungseinheit (3) und die zweite Erfassungseinheit (4) an einer gemeinsamen X-Y-Positioniervorrichtung angebracht sind und/oder optische Achsen der ersten Erfassungseinheit (3) und der zweiten Erfassungseinheit (4) zueinander ausgerichtet oder zugeordnet sind, vorzugsweise eine gemeinsame optische Achse aufweisen.

13. Vorrichtung nach Anspruch 9, wobei die dritte Erfassungseinheit (7) zumindest gegenüber der ersten Erfassungseinheit (3), insbesondere gegenüber einem optischen System (2) aus der der ersten Erfassungseinheit (3) und der zweiten Erfassungseinheit (4), während der Erfassung zumindest bis zur Ausrichtung in X- und Y-Richtung ortsfest angeordnet wird, vorzugsweise keine Freiheitsgrade aufweist.

## Claims

1. A method for aligning and contacting a first contact face (16i) of a first substrate (16) with a second contact face (17i) of a second substrate (17) with the following steps, in particular the following sequence:
- fixing of a first support face (16o) of the first substrate (16) on a first substrate holder (10) and a second support face (17o) of the second substrate (17) on a second substrate holder (13), which can be arranged opposite the first substrate holder (10),
- detection of a first X-Y position, in particular related to a focal plane (12) of a first detection unit (3), and/or first alignment orientation of a first alignment marking (20) arranged in particular in a peripheral region of the first substrate (16),
- detection of a second X-Y position, in particular related to a focal plane (12) of a second detection unit (4), and/or second alignment orientation of a second alignment marking (21) arranged in particular in a peripheral region of the second substrate (17),
- alignment of the first substrate (16) with respect to the second substrate (17), and
- contacting of the first substrate (16) with the second substrate (17), said first substrate being aligned with respect to the second substrate (17),
**characterised in that**,
before the alignment, a detection of a third X-Y position and/or third alignment orientation of the first substrate holder (10) and/or the first substrate (16) also takes place by a third detection unit (7), by means of which the alignment is controlled, wherein the first alignment marking (20) and the third alignment marking (22) are arranged on different sides of the first substrate (16) or of the first substrate holder (3), said sides in particular lying mutually opposite in a Z-direction.

2. The method according to claim 1, wherein the detection of the first alignment marking (20) and of the third alignment marking (22) takes place in a combined process step, in particular simultaneously, preferably by synchronising the first detection unit (3) and the third detection unit (7).

3. The method according to any one of the preceding claims, wherein the second substrate holder (13) is fixed at least in the X-Y direction during the alignment.

4. The method according to any one of the preceding claims, wherein the first detection unit (3) and the second detection unit (4) are provided on a common X-Y positioning device and/or optical axes of the first detection unit (3) and of the second detection unit (4) are aligned with or assigned to one another, preferably having a common optical axis.

5. The method according to any one of the preceding claims, wherein the third detection unit (7) is arranged fixedly in the X- and Y-direction, preferably has no degrees of freedom, at least with respect to the first detection unit (3), in particular with respect to an optical system (2) comprising the first detection unit (3) and the second detection unit (4), during the detection at least up to the alignment.

6. The method according to any one of the preceding claims, wherein the control of the alignment takes place exclusively by means of the detection of the third X-Y position and/or third alignment orientation.

7. The method according to any one of the preceding claims, wherein the first substrate and the second substrate are arranged between the first substrate holder and the second substrate holder with an, in particular constant, spacing A between the first contact face and the second contact face in a Z-direction during the detections and up to the alignment.

8. The method according to claim 7, wherein spacing A amounts to less than 500 microns, particularly preferably less than 100 microns, in the optimum case less than 50 microns, in the ideal case less than 10 microns.

9. A device for aligning and contacting a first contact face (16i) of a first substrate (16) with a second contact face (17i) of a second substrate (17) with:
- a first substrate holder (10) for fixing a first support face (160) of the first substrate (16),
- a second substrate holder (13) for fixing a second support face (17o) of the second substrate (17), said second substrate holder being able to be arranged lying opposite the first substrate holder (10),
- a first detection unit (3) for detecting a first X-Y position and/or first alignment orientation of a first alignment marking (20),
- a second detection unit (4) for detecting a second X-Y position and/or second alignment orientation of a second alignment marking (21),
- alignment means for aligning the first substrate (16) with respect to the second substrate (17), and
- contacting means (15) for contacting the first substrate (16) with the second substrate (17), said first substrate being aligned with respect to the second substrate (17),
**characterised in that**
the device comprises a third detection unit (7) for detecting a third X-Y position and/or third alignment orientation of the first substrate holder (10) and/or the first substrate (16), by means of which the alignment can be controlled, wherein the first alignment marking (20) and the third alignment marking (22) are arranged on different sides of the first substrate (16) or of the first substrate holder (3), said sides in particular lying mutually opposite in a Z-direction.

10. The device according to claim 9, wherein the first detection unit (3) and the third detection unit (7) can be synchronised or are synchronised.

11. The device according to claim 9, wherein the second substrate holder (13) is constituted capable of being fixed at least in the X-Y direction during the alignment.

12. The device according to claim 9, wherein the first detection unit (3) and the second detection unit (4) are provided on a common X-Y positioning device and/or optical axes of the first detection unit (3) and of the second detection unit (4) are aligned with or assigned to one another, preferably having a common optical axis.

13. The device according to claim 9, wherein the third detection unit (7) is arranged fixedly in the X- and Y-direction, preferably has no degrees of freedom, at least with respect to the first detection unit (3), in particular with respect to an optical system (2) comprising the first detection unit (3) and the second detection unit (4), during the detection at least up to the alignment.

## Revendications

1. Procédé pour aligner et mettre en contact une première surface de contact (16i) d'un premier substrat (16) avec une deuxième surface de contact (17i) d'un second substrat (17), comprenant les étapes suivantes, en particulier le déroulement suivant :
- fixation d'une première surface d'appui (16o) du premier substrat (16) sur un premier support de substrat (10) et d'une seconde surface d'appui (17o) du second substrat (17) sur un second support de substrat (13) qui peut être agencé opposé au premier support de substrat (10)
- détection d'une première position X-Y et/ou d'une première position d'alignement rapportée en particulier à un plan de mise au point (12) d'une première unité de détection (3), d'un premier marquage d'alignement (20) disposé en particulier dans une zone périphérique du premier substrat (16),
- détection d'une deuxième position X-Y et/ou d'une deuxième position d'alignement rapportée en particulier à un plan de mise au point (12) d'une deuxième unité de détection (4), d'un deuxième marquage d'alignement (21) disposé en particulier dans une zone périphérique du deuxième substrat (17),
- alignement du premier substrat (16) par rapport au second substrat (17), et
- mise en contact du premier substrat (16) avec le second substrat (17), aligné par rapport au second substrat (17),
**caractérisé en ce que**
avant l'alignement, une détection d'une troisième position X-Y et/ou d'une troisième position d'alignement du premier support de substrat (10) et/ou du premier substrat (16) est effectuée en plus par une troisième unité de détection (7), au moyen de laquelle l'alignement est commandé, dans lequel le premier marquage d'alignement (20) et le troisième marquage d'alignement (22) sont disposés sur différents côtés du premier substrat (16) ou du premier support de substrat (3), opposés en particulier dans un sens Z.

2. Procédé selon la revendication 1, dans lequel la détection du premier marquage d'alignement (20) et du troisième marquage d'alignement (22) s'effectue dans une seule et même étape de procédé, en particulier simultanément, de préférence par synchronisation de la première unité de détection (3) et de la troisième unité de détection (7).

3. Procédé selon l'une des revendications précédentes, dans lequel le second support de substrat (13) est fixé au moins dans le sens X-Y pendant l'alignement.

4. Procédé selon l'une des revendications précédentes, dans lequel la première unité de détection (3) et la deuxième unité de détection (4) sont appliquées sur un dispositif de positionnement X-Y commun et/ou des axes optiques de la première unité de détection (3) et de la deuxième unité de détection (4) sont alignés ou mis en correspondance l'un par rapport à l'autre, présentent de préférence un axe optique commun.

5. Procédé selon l'une des revendications précédentes, dans lequel la troisième unité de détection (7) est agencée fixe, ne présente de préférence aucun degré de liberté, au moins par rapport à la première unité de détection (3), en particulier par rapport à un système optique (2) de la première unité de détection (3) et de la deuxième unité de détection (4), pendant la détection au moins jusqu'à l'alignement dans le sens X et Y.

6. Procédé selon l'une des revendications précédentes, dans lequel la commande de l'alignement s'effectue exclusivement au moyen de la détection de la troisième position X-Y et/ou de la troisième position d'alignement.

7. Procédé selon l'une des revendications précédentes, dans lequel le premier substrat et le second substrat, pendant les détections et jusqu'à l'alignement, sont disposés dans un sens Z entre le premier support de substrat et le second support de substrat avec une distance A, en particulier constante, entre la première surface de contact et la seconde surface de contact.

8. Procédé selon la revendication 7, dans lequel la distance A est inférieure à 500 micromètres, particulièrement de préférence inférieure à 100 micromètres, dans le cas optimal inférieure à 50 micromètres, dans le cas idéal inférieure à 10 micromètres.

9. Dispositif pour aligner et mettre en contact une première surface de contact (16i) d'un premier substrat (6) avec une deuxième
surface de contact (17i) d'un second substrat (17), comprenant les étapes suivantes, en particulier le déroulement suivant :
- un premier support de substrat (10) pour la fixation d'une première surface d'appui (16o) du premier substrat (16)
- un second support de substrat (13) qui peut être agencé opposé au premier support de substrat (10) pour la fixation d'une seconde surface d'appui (17o) du second substrat (17),
- une première unité de détection (3) pour la détection d'une première position X-Y et/ou d'une première position d'alignement d'un premier marquage d'alignement (20)
- une deuxième unité de détection (4) pour la détection d'une deuxième position X-Y et/ou d'une deuxième position d'alignement d'un deuxième marquage d'alignement (21),
- des moyens d'alignement pour aligner le premier substrat (16) par rapport au second substrat (17), et
- des moyens de mise en contact (15) pour la mise en contact du premier substrat (16) avec le second substrat (17), aligné par rapport au second substrat (17),
**caractérisé en ce que**
le dispositif présente une troisième unité de détection (7) pour détecter une troisième position X-Y et/ou une troisième position d'alignement du premier support de substrat (10) et/ou du premier substrat (16), au moyen de laquelle l'alignement peut être commandé, dans lequel le premier marquage d'alignement (20) et le troisième marquage d'alignement (22) sont disposés sur différents côtés du premier substrat (16) ou du premier support de substrat (3), opposés en particulier dans un sens Z.

10. Dispositif selon la revendication 9, dans lequel la première unité de détection (3) et la troisième unité de détection (7) peuvent être synchronisées ou sont synchronisées.

11. Dispositif selon la revendication 9, dans lequel le deuxième support de substrat (13) est conçu en pouvant être fixé au moins dans le sens X-Y pendant l'alignement.

12. Dispositif selon la revendication 9, dans lequel la première unité de détection (3) et la deuxième unité de détection (4) sont placées sur un dispositif de positionnement X-Y commun et/ou des axes optiques de la première unité de détection (3) et de la deuxième unité de détection (4) sont alignés ou mis en correspondance entre eux, présentent de préférence un axe optique commun.

13. Dispositif selon la revendication 9, dans lequel la troisième unité de détection (7), au moins par rapport à la première unité de détection (3), en particulier par rapport à un système optique (2) de la première unité de détection (3) et de la deuxième unité de détection (4), est disposé fixe, ne présente de préférence aucun degré de liberté, pendant la détection au moins jusqu'à l'alignement dans le sens X et Y.
